**Europäisches Patentamt**

**European Patent Office**

**Office européen des brevets**

(19)

(11) Veröffentlichungsnummer: **0 006 985**
**B1**

(12) **EUROPÄISCHE PATENTSCHRIFT**

(45) Veröffentlichungstag der Patentschrift:
26.08.81

(51) Int. Cl.³: **H 01 J 37/21**

(21) Anmeldenummer: **79101502.7**

(22) Anmeldetag: **16.05.79**

(54) **Verfahren und Vorrichtung zur Brennweitenbestimmung langbrennweitiger elektronenoptischer Linsen.**

(30) Priorität: **16.06.78 DE 2827085**

(43) Veröffentlichungstag der Anmeldung:
**23.01.80 Patentblatt 80/2**

(45) Bekanntmachung des Hinweises auf die Patenterteilung:
**26.08.81 Patentblatt 81/34**

(84) Benannte Vertragsstaaten:
**FR GB NL**

(56) Entgegenhaltungen:
**DE-B-2 515 549**
**DE-B-2 515 550**

(73) Patentinhaber: **SIEMENS AKTIENGESELLSCHAFT Berlin und München, Postfach 22 02 61, D-8000 München 22 (DE)**

(72) Erfinder: **Anger, Klaus, Dipl,-Ing., Milowstrasse 2, D-1000 Berlin 33 (DE)**
Erfinder: **Lischke, Burkhard, Dr., Albrechtstrasse 59a, D-1000 Berlin 41 (DE)**
Erfinder: **Frosien, Jürgen, Dipl.-Ing., Tile-Brügge-Weg 40, D-1000 Berlin 27 (DE)**

ACTORUM AG.

Verfahren und Vorrichtung zur Brennweitenbestimmung langbrennweitiger elektronenoptischer Linsen

Die Erfindung betrifft ein Verfahren und eine Vorrichtung zur Brennweitenbestimmung langbrennweitiger elektronenoptischer Linsen, insbesondere für einen Mikroprojektor.

Für die Herstellung hochintegrierter Schaltkreise werden in einem Mikroprojektor grossflächige Transmissionsmasken mehrfach verkleinert auf einen sogenannten Wafer, z.B. eine einkristalline Siliziumscheibe, abgebildet, um einzelne Strukturdetails passgerecht aufeinanderzufügen. Mit fortschreitender Miniaturisierung wachsen dabei die Anforderungen an das Abbildungssystem. Der zulässige Versatz relativ zum Bildfelddurchmesser beträgt etwa $2 \times 10^{-5}$, wenn Strukturen mit einer Lagegenauigkeit von 0,1 μm auf einem Bildfeld von 5 mm erzeugt werden sollen. Um diese Genauigkeit auch bei mehrmaliger Belichtung erreichen zu können, müssen für die Einstellung des Mikroprojektors, des Strahlenganges und insbesondere der Vergrösserung die Brennweiten der verwendeten Linsen sehr genau bekannt sein.

Bei herkömmlichen elektronenoptischen Geräten, beispielsweise Elektronenmikroskopen, können die Brennweiten durch Vergrösserungsmessungen mit einem bekannten Testobjekt bestimmt werden. Wegen der hohen möglichen Vergrösserungswerte und der geringeren Genauigkeitsanforderungen als beim Mikroprojektor ist diese Methode ausreichend.

Bei einem Mikroprojektor hingegen wird die Transmissionsmaske nur etwa um den Faktor 1:10 verkleinert auf den Wafer abgebildet. Die bekannte Methode zur Brennweitenmessung bringt daher nicht die erforderliche Genauigkeit.

Der Erfindung liegt die Aufgabe zugrunde, ein Verfahren anzugeben, mit dessen Hilfe die Brennweiten und Hauptebenen langbrennweitiger elektronenoptischer Linsen mit hoher Genauigkeit bestimmt werden können. Diese Aufgabe wird erfindungsgemäss dadurch gelöst, dass auf die Linse ein aus achsparallelen Strahlen bestehendes, im Querschnitt ringförmiges Strahlenbündel mit dem mittleren Radius R auftrifft, dass mit einer Lochblende, deren Durchmesser etwa dem Durchmesser des Fehlerscheibchens der Linse für das ringförmige Strahlenbündel entspricht, die Lage der hinteren Brennebene als Ort geringster Beeinflussung des durch die Lochblende hindurchtretenden Strahlenbündels bestimmt wird, dass in einer in Strahlrichtung hinter der Lochblende im Abstand $z_2$ liegenden Ebene der mittlere Radius r des ringförmigen Strahlenbündels bestimmt wird und dass aus den Grössen R, r, $z_2$ die Brennweite f nach der Formel $f = \frac{R}{r} \times z_2$ ermittelt wird.

Die erreichbare Genauigkeit bei der Brennweitenbestimmung hängt also von der Genauigkeit ab, mit der R, r und $z_2$ bestimmt werden können. Der Radius R lässt sich recht genau ausmessen, so dass der dabei auftretende Fehler gegen die Fehler bei der Bestimmung des Abstandes $z_2$ und

des Radius r vernachlässigt werden kann. Die Genauigkeit des Verfahrens zur Brennweitenbestimmung hängt also im wesentlichen von der Genauigkeit ab, mit der die Lage der hinteren Brennebene und der Radius r des ringförmigen Strahlenbündels ermittelt werden kann. Für den relativen Fehler bei der Brennweitenbestimmung kann man somit schreiben

$$\frac{\triangle f}{f} = \frac{\triangle z_2}{z_2} + \frac{\triangle r}{r}$$

Durch die erfindungsgemässe Verwendung des Strahlenbündels ringförmigen Querschnittes lässt sich die Lage der Brennebene sehr gut bestimmen, wie die folgenden Überlegungen verdeutlichen:

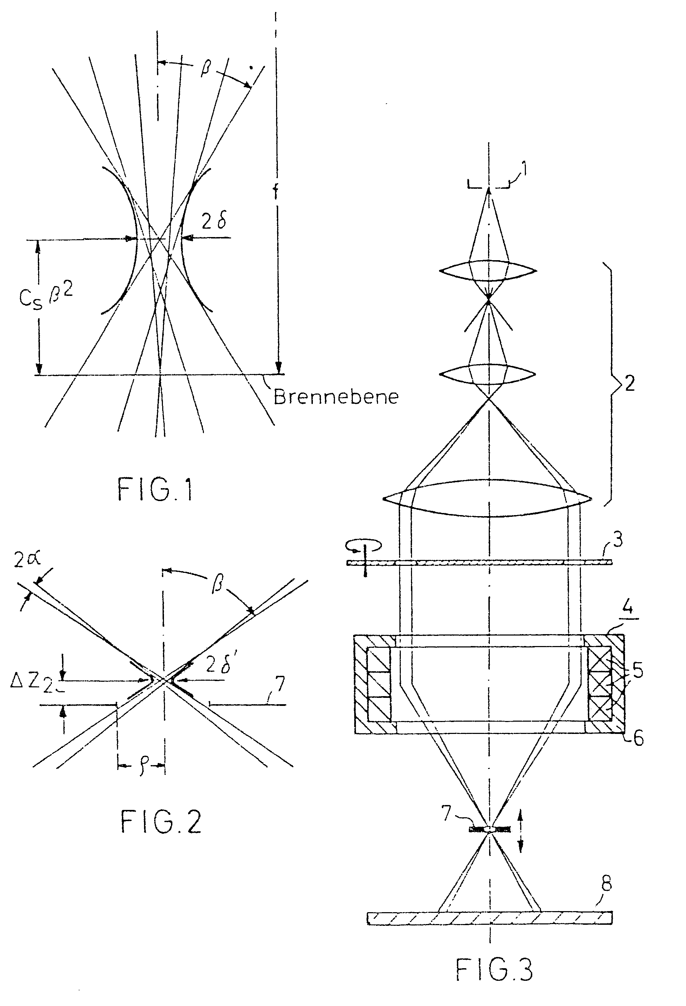

In der Figur 1 ist der prinzipielle Strahlengang für den Fall angegeben, dass alle Strahlen vom Achsabstand Null bis zu einem maximalen Abstand zugelassen sind. Wegen des Öffnungsfehlers $C_s$ der Linse schneiden Strahlen, die mit unterschiedlichem Achsabstand auf die Linse auftreffen, die Achse nach dem Verlassen der Linse an unterschiedlichen Stellen. Die Brennebene ist daher als die Ebene definiert, in der die Strahlen, die mit beliebig kleinem Winkel gegen die optische Achse verlaufen, die Achse schneiden (paraxiale Strahlen). Der Öffnungsfehler $C_s$ der Linse bewirkt, dass die Strahlen mit grösserem Winkel β gegen die Achse diese um den Abstand $C_s \times \beta^2$ vor der Brennebene schneiden.

Der kleinste Durchmesser der Einhüllenden bestimmt die Ebene kleinster Verwirrung und ist mit 2δ bezeichnet. Er gibt die Grösse eines Öffnungsfehlerscheibchens an. Wie man dieser Figur 1 entnehmen kann, ändert sich der Durchmesser der Einhüllenden in einem grossen Achsenbereich nur sehr wenig. Wollte man bei diesem Strahlenverlauf mit einer Lochblende die Brennebene bestimmen, gelänge das nur mit grosser Ungenauigkeit, da eine Verschiebung der Lochblende entlang der optischen Achse in einem grossen Bereich keinen Einfluss auf die durchgelassene Intensität des Strahlenbündels hätte.

Durch die Verwendung eines Strahlenbündels ringförmigen Querschnittes wie bei dem erfindungsgemässen Verfahren lässt sich die Brennweite sehr viel genauer bestimmen. In der Figur 2 ist der entsprechende Strahlengang dargestellt. Wegen des grossen Radius des auf die Linse auftreffenden Strahlenbündels ist der Winkel β zwischen der Achse und dem in der Linse gebrochenen Strahl gross. Da der Winkel 2α zwischen den extremen Strahlen des Strahlenbündels sehr klein ist im Verhältnis zum Winkel β, ergibt sich eine Einhüllende mit einer starken Einschnürung und damit ein kleiner Durchmesser 2δ' des Fehlerscheibchens.

Die daraus bestimmte Brennweite weicht von der für paraxiale Strahlen definierten Linsenbrennweite um den Betrag $C_s\beta^2$ ab. Wenn dieser Betrag der gemessenen Brennweite zugezählt werden soll, dann muss der Öffnungsfehler $C_s$ bekannt sein. Da diese Korrektur aber bei günstiger Dimensionierung der Ringfeldblende geringfügig ist – es gilt dann $C_s\beta^2 \ll f$ – muss $C_s$ nur ungefähr bekannt sein, um noch eine hohe Genauigkeit der Brennweite zu erreichen. $C_s$ lässt sich aus den Linsendaten berechnen.

Nimmt man an, dass das Bild der Elektronenstrahlquelle punktförmig ist und dass die Lochblende 7 einen Durchmesser $2\varsigma$ hat, so erhält man eine Unbestimmtheit der Strecke $z_2$ von $\triangle z_2 = \frac{1}{\beta} \times \varsigma$. Um die Unbestimmtheit $\triangle z_2$ klein zu machen, muss der Winkel $\beta$ gross und der Durchmesser der Lochblende 7 klein sein. Letzterer muss aber mindestens so gross wie der Durchmesser des Fehlerscheibchens sein, um die Gesamtintensität des Strahlenbündels durch die Lochblende 7 hindurchzulassen.

Andererseits wächst mit $\beta$ auch das Fehlerscheibchen in der Blendenebene (Fig. 2) gemäss der Formel $2\,\delta' = 6\,C_s\beta^2\alpha$, so dass der erforderliche Blendendurchmesser $2\varsigma$ ebenfalls ansteigt. Je kleiner $C_s$ oder $\beta$ oder $\alpha$ sind, desto kleiner kann auch $2\varsigma$ und um so genauer die $z_2$-Bestimmung sein.

Diese gegensätzlichen Anforderungen an $\beta$ legen nahe, dass es einen optimalen Winkel $\beta$ und damit einen optimalen Ringdurchmesser R gibt. Er ergibt sich aus der Bedingung, dass der Messfehler für den Strahldurchmesser $2\,r$ hinter der Lochblende etwa gleich dem Messfehler bei der Bestimmung der Lage der Brennebene sein soll:

$$R_{opt} \approx f \sqrt{\frac{\triangle r}{6\,C_s\delta}}$$

Die Lage der der Brennweite zugeordneten Hauptebenen ergibt sich aus der Differenz zwischen der gemessenen Linsenbrennweite und dem Abstand zwischen der Lochblendenebene und der mechanischen Linsenmitte. Die Messgenauigkeit hängt allein von der Präzision ab, mit der die Brennweite bestimmt werden kann.

Weiterhin liegt der Erfindung die Aufgabe zugrunde, eine Vorrichtung anzugeben, mit der bei einem Mikroprojektor die Brennweitenbestimmung wiederholt durchgeführt werden kann. Diese weitere Aufgabe wird erfindungsgemäss durch ein in Strahlrichtung vor der langbrennweitigen Linse liegendes Kondensorlinsensystem, in dessen vorderer Brennebene sich eine Elektronenstrahlquelle befindet, eine zwischen Kondensorlinsensystem und langbrennweitiger Linse in den Strahlengang schwenkbare Ringfeldblende, eine in Strahlrichtung hinter der langbrennweitigen Linse ebenfalls in den Strahlengang schwenkbare Lochblende sowie eine Registriereinrichtung für das durch die Lochblende hindurchtretende Strahlenbündel gelöst.

Durch die schwenkbare Ringfeldblende kann ein achsparalleles Strahlenbündel ringförmigen Querschnitts ausgeblendet werden. Mit der Lochblende wird die hintere Brennebene vorteilhaft ermittelt, indem die Blende entlang der Achse hin und her verschoben wird, bis sich eine optimale Ausleuchtung in der Registrierebene ergibt. Ebenso ist es möglich, die Erregung der Linse solange zu ändern, bis die Brennebene mit der Ebene einer feststehenden Lochblende zusammenfällt.

Im Hinblick auf eine konstruktive Ausgestaltung der Vorrichtung empfiehlt es sich, dass als Registrierebene eine Fotoplatte vorgesehen ist. Nach dem Entwickeln der Platte läst sich der Radius r sehr genau ausmessen.

Eine vorteilhafte Ausgestaltung der Vorrichtung ergibt sich jedoch auch dann, wenn als Registriereinrichtung ein entlang der optischen Achse der Vorrichtung verschiebbarer ringscheibenförmiger Detektor vorgesehen ist. Dieser Detektor hat einen fest vorgegebenen Radius r. Er muss solange verschoben werden, bis er das Strahlenbündel erfasst. Dann ist die Ebene ermittelt, in der das Strahlenbündel ebenfalls den Radius r besitzt.

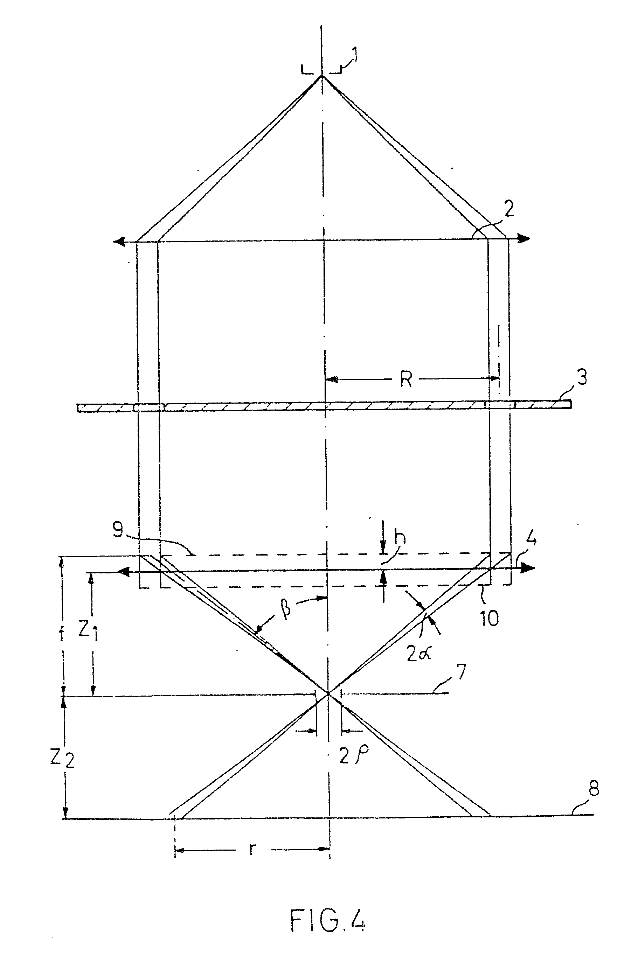

Anhand der Figuren 3 und 4 wird im folgenden ein Ausführungsbeispiel einer Vorrichtung zur Brennweitenbestimmung bei einem Mikroprojektor und das Verfahren dazu beschrieben und erläutert.

Fig. 3 zeigt dabei den schematischen Aufbau des Mikroprojektors mit der erfindungsgemässen Vorrichtung.

Fig. 4 zeigt den Strahlengang bei der Brennweitenbestimmung.

In Fig. 3 ist mit 1 die Elektronenquelle bezeichnet, mit 2 ein dreistufiges Kondensorlinsensystem zur Erzeugung eines Strahlenbündels im wesentlichen achsparalleler Strahlen. Unterhalb des Kondensorlinsensystems 3 befindet sich eine in den Strahlengang einschwenkbare Ringfeldblende 3. Unterhalb der Ringfeldblende 3 befindet sich die langbrennweitige magnetische Linse 4, deren Brennweite bestimmt werden soll.

In diesem speziellen Ausführungsbeispiel handelt es sich bei der langbrennweitigen magnetischen Linse um eine Linse mit mehreren separat erregbaren Wicklungen 5 und einem diese Wicklungen am Aussenmantel und an den Stirnflächen umgebenden Eisenmantel 6. In der hinteren Brennebene dieser Linse 4 befindet sich eine ebenfalls in den Strahlengang schwenkbare Lochblende 7, die entlang der optischen Achse des Mikroprojektors verschoben werden kann. Unterhalb der Lochblende 7 befindet sich als Registriereinrichtung eine Fotoplatte 8.

Für die Abbildung einer hier nicht dargestellten Transmissionsmaske auf einen hier ebenfalls nicht dargestellten Wafer werden sowohl die Ringfeldblende 3 als auch die Lochblende 7 aus dem Strahlengang herausgenommen. Wegen der hohen Anforderung an die Genauigkeit der Verkleinerung, die mit der langbrennweitigen Linse 4 eingestellt wird, ist es notwendig, die Brennweite dieser Linse in Abständen zu kontrollieren. Zumindest kann es nach jedem neuen Einschalten des Mikroprojektors erforderlich sein, eine Brennweitenbestimmung vorzunehmen.

Fig. 4 zeigt noch einmal etwas vereinfacht den Strahlengang des Mikroprojektors während der Brennweitenbestimmung. Dabei ist anstelle des Kondensorlinsensystems 2 eine einzelne Kondensorlinse durch ihre Hauptebene angedeutet. Gleiche Teile sind mit gleichen Bezugszeichen wie bei der vorhergehenden Figur 3 versehen.

Der Kondensor 2 erzeugt aus dem von der Quelle 1 kommenden divergenten Strahlenbündel ein Bündel achsparallel verlaufender Elektronenstrahlen. Durch die Ringfeldblende 3 wird aus diesem Bündel ein Strahlenbündel ringförmigen Querschnittes ausgeblendet. Der Radius R dieses ringförmigen Strahlenbündels beträgt einige cm. Mit Radius ist dabei immer der mittlere Radius des Ringes gemeint. Die Breite des Ringes ist gegen den Radius vernachlässigbar klein.

Von der langbrennweitigen Linse 4, deren Brennweite bestimmt werden soll, ist lediglich die geometrische Mitte bekannt, jedoch nicht die Hauptebenen, von denen aus die Brennweite gerechnet werden muss. Gestrichelt sind neben der durch die durchgezogene Linie angedeuteten mechanischen Mitte der Linse mögliche Hauptebenen 9, 10 angedeutet. Die durch die Linse abgelenkten Elektronenstrahlen schneiden die optische Achse in der hinteren Brennebene; es entsteht ein Bild der Quelle. Die Lage dieser Brennebene soll mit Hilfe der Lochblende 7 festgelegt werden. Mit welcher Genauigkeit das möglich ist, ist bereits anhand der Figur 2 erläutert worden. Unterhalb der Blende befindet sich eine Fotoplatte 8, auf der das Strahlenbündel registriert werden kann. Auf der Fotoplatte kann der Radius r dieses Strahlenbündels ausgemessen werden. Ist die Lage der hinteren Brennebene durch die Lochblende 7 bestimmt, so ist auch der Abstand $z_2$ zwischen dieser Blende und der Fotoplatte 8 gegeben. Damit sind alle Grössen zur Bestimmung der Brennweite vorhanden. Ebenso ist dann der Abstand $z_1$ zwischen der Lochblende 7 und der mechanischen Mitte der Linse 4 bekannt, und der Hauptebenenabstand h ergibt sich gemäss $h = f - z_1$.

An einem Beispiel sei noch einmal der Vorteil der Einführung der Ringfeldblende für die Genauigkeit bei der Bestimmung der Brennweite demonstriert. Der Öffnungsfehler der Linse sei $C_s = 2,33 \times 10^3$ mm; dieser Wert lässt sich aus den Linsendaten theoretisch berechnen. Weiter sei angenommen, dass der Winkel $\beta = 6,6 \times 10^{-2}$ rad und der Winkel $\alpha = 5,3 \times 10^{-4}$ rad beträgt.

Berechnet man das Fehlerscheibchen in der hinteren Brennebene für den Fall, dass der gesamte Querschnitt der Linse 4 ausgenutzt wird, d.h. also ohne die Ringfeldblende, so ergibt sich für den Durchmesser $2\delta$ des Fehlerscheibchens $2\delta = 2 \times C_s \times \beta^3 = 1,34$ mm.

Wird jedoch die Ringfeldblende 3 in den Strahlengang eingefügt, so ergibt sich für das Fehlerscheibchen $2\delta' = 6 \times C_s \times \beta^2 \times \triangle\alpha = 33$ μm. Durch die Einführung der Ringfeldblende wird das Fehlerscheibchen drastisch verringert. Als Folge davon ist die Bestimmung der Brennweite mit hoher Präzision möglich, da der Durchmesser der Lochblende in gleichem Masse verkleinert werden kann. Wie bereits früher ausgeführt, muss der Durchmesser der Lochblende mindestens so gross wie der Durchmesser des Fehlerscheibchens sein, um die gesamte Intensität durch die Blende hindurchzulassen. Andererseits soll der Durchmesser zur genauen Lagebestimmung der hinteren Brennebene so klein wie möglich sein. Bei bekannter Grösse des Fehlerscheibchens – diese Grösse lässt sich wie eben gezeigt berechnen – wird man daher den Durchmesser der Lochblende 7 annähernd gleich der Grösse des Durchmessers des Fehlerscheibchens machen. Für die Unbestimmtheit der Strecke $z_2$, die gegeben war durch $\triangle z_2 = \frac{1}{\beta}\varsigma$ kann man dann näherungsweise schreiben:

$$\triangle z_2 \approx \frac{1}{\beta} \delta'$$

Nimmt man weiter an, dass der Radius r des Strahlenbündels in der Registrierebene 10 mm beträgt und auf 20 μm genau ausgemessen werden kann, dann ergibt sich für die relative Brennweitengenauigkeit

$$\frac{\triangle f}{f} \approx \frac{3 C_s \cdot \beta\triangle\alpha}{z_2} + \frac{\triangle r}{r} \approx 3 \cdot 10^{-3}$$

Auf diese Weise können auch die Brennweiten langbrennweitiger elektronenoptischer Linsen auf Promille genau bestimmt werden.

Anhand dieses Beispiels ist noch einmal deutlich geworden, dass im Gegensatz zur Darstellung in den Figuren die auftretenden Winkel so klein sind, dass in guter Näherung bei der Ableitung der verwendeten Formeln jeweils der Tangens durch sein Argument ersetzt werden konnte.

**Patentansprüche**

1. Verfahren zur Brennweitenbestimmung langbrennweitiger elektronenoptischer Linsen, insbesondere für einen Mikroprojektor, dadurch gekennzeichnet, dass auf die Linse ein aus achsparallelen Strahlen bestehendes, im Querschnitt ringförmiges Strahlenbündel mit dem mittleren Radius R auftrifft, dass mit einer Lochblende (7), deren Durchmesser etwa dem Durchmesser des Fehlerscheibchens der Linse (4) für das ringförmige Strahlenbündel entspricht, die Lage der hinteren Brennebene als Ort geringster Beeinflussung des durch die Lochblende (7) hindurchtretenden Strahlenbündels bestimmt wird, dass in einer in Strahlrichtung hinter der Lochblende (7) im Abstand $z_2$ liegenden Ebene (8) der mittlere Radius r des ringförmigen Strahlenbündels bestimmt wird und dass aus den Grössen R, r, $z_2$ die Brennweite f nach der Formel $f = \frac{R}{r} \times z_2$ ermittelt wird.

2. Vorrichtung zur Durchführung des Verfahrens nach Anspruch 1, gekennzeichnet durch ein in Strahlrichtung vor der langbrennweitigen Linse (4) liegendes Kondensorlinsensystem (2), in dessen vorderer Brennebene sich eine Elektronenstrahlquelle (1) befindet, eine zwischen Kondensorlinsensystem (2) und langbrennweitiger Linse (4) in den Strahlengang schwenkbare Ringfeldblende (3), eine in Strahlrichtung hinter der langbrennweitigen Linse (4) ebenfalls in den Strahlengang schwenkbare Lochblende (7) sowie eine Registriereinrichtung (8) für das durch die Lochblende (7) hindurchtretende Strahlenbündel.

3. Vorrichtung nach Anspruch 2, dadurch gekennzeichnet, dass die Lochblende (7) entlang der optischen Achse verschiebbar ist.

4. Vorrichtung nach Anspruch 2 oder 3, dadurch gekennzeichnet, dass als Registriereinrichtung eine Fotoplatte (8) vorgesehen ist.

5. Vorrichtung nach Anspruch 2 oder 3, dadurch gekennzeichnet, dass als Registriereinrichtung ein entlang der optischen Achse der Vorrichtung verschiebbarer ringscheibenförmiger Detektor mit dem mittleren Radius r vorgesehen ist.

**Claims**

1. A process for determining the focal length of long-focussed optoelectronic lenses, in particular for a micro-projector, characterised in that a beam of axially parallel rays which is annular in cross-section and has the mean radius R impinged upon the lens, that a diaphragm (7) whose diameter approximately corresponds to the diameter of the circle of least confusion of the lens (4) for the annular beam is used to determine that position of the back focal plane as the place of minimum influence of the beam which penetrates the diaphragm (7), and that in a plane (8) arranged in the beam direction behind the diaphragm (7) at the distance $z_2$, there is determined the mean radius r of the annular beam, and that the focal length f is determined from the magnitudes R, r and $z_2$ in accordance with the formula $f = \frac{R}{r} \times z_2$.

2. A device for implementing the process as claimed in Claim 1, characterised by a condenser lens system (2) which lies in the beam direction in front of the lens (4) having a long focal length, and in whose front focal plane is located an electron-beam source (1), a ring-field diaphragm (3) which can be swung into the beam path between the condenser lens system (2) and the lens (4), a diaphragm (7) which can likewise be swung into the beam path in the beam direction behind the lens (4), and a recording device (8) for the beam which penetrates through the diaphragm (7).

3. A device as claimed in Claim 2, characterised in that the diaphragm (7) can be moved along the optical axis.

4. A device as claimed in Claim 2 or Claim 3, characterised in that a photo-sensitive plate (8) is provided as recording device.

5. A device as claimed in Claim 2 or Claim 3, characterised in that an annular detector which has the mean radius r and which can be moved along the optical axis of the device is provided as a recording device.

**Revendications**

1) Procédé pour déterminer la distance focale de lentilles optoélectroniques de grande focale, plus particulièrement pour un microprojecteur, caractérisé par le fait qu'il consiste à diriger sur la lentille un faisceau de rayons de sdection transversale annulaire de rayon moyen R et constitué par des rayons parallèles à l'axe, à déterminer, à l'aide d'un diaphragme à petite ouverture (7) dont le dimètre correspond sensiblement au diamètre du cercle d'aberration de la lentille (4) pour le faisceau annulaire, la position du plan focal arrière, comme emplacement de plus faible influence du faisceau de rayons passant par le diaphragme à petite ouverture (7) à, à déterminer, dans un plan (8) situé à une distance $z_2$ derrière le diaphragme à petite ouverture (7), dans le sens de la marche des rayons moyen r du faisceau de rayons annulaire et à déterminer, à partir des valeurs R, r et $z_2$, la distance focale f selon la relation $f = \frac{R}{r} \times z_2$.

2) Dispositif pour la mise en œuvre du procédé selon la revendication 1, caractérisé par un système de lentilles de condensateur (2) situé, dans le sens de la marche des rayons, en avant de la lentille (4) de grande longueur focale, et dans le plan focal avant duquel est située une source de rayons électroniques (1), par un diaphragme de champ annulaire (3) susceptible d'être basculé dans la trajectoire des rayons, entre le système de lentilles de condensateur (2) et la lentille (4) de grande longueur focale, par un diaphragme (7) à petite ouverture également susceptible d'être basculé dans la trajectoire des rayons, derrière la lentille (4) de grande longueur focale, et par un dispositif d'enregistrement (8) pour le faisceau de rayons passant par le diaphragme (7) à petite ouverture.

3) Dispositif selon la revendication 2, caractérisé par le fait que le diaphragme (7) à petite ouverture est déplaçable le long de l'axe optique.

4) Dispositif selon la revendication 2 ou 3, caractérisé par le fait que le dispositif d'enregistrement est une plaque photographique.

5) Dispositif selon la revendication 2 ou 3, caractérisé par le fait qu'au titre de dispositif d'enregistrement, il est prévu un détecteur de forme annulaire de rayon moyen r, réplaçable le long de l'axe optique du dispositif.

FIG.1

FIG.2

FIG.3

FIG.4